# EUROPÄISCHE PATENTSCHRIFT

(11) **EP 1 264 350 B1**
(45) Veröffentlichungstag und Bekanntmachung des Hinweises auf die Patenterteilung: **08.11.2006**
(21) Anmeldenummer: 01929238.2
(22) Anmeldetag: 09.03.2001
(51) Int. Cl.: H01L 29/78, H01L 29/10, H01L 27/07

(54) **VERTIKALES HOCHVOLT-HALBLEITERBAUELEMENT**
VERTICAL HIGH-VOLTAGE SEMICONDUCTOR COMPONENT
COMPOSANT SEMI-CONDUCTEUR HAUTE TENSION VERTICAL

(30) Priorität: 15.03.2000 DE 10012610
(43) Veröffentlichungstag der Anmeldung: 11.12.2002
(73) Patentinhaber: Infineon Technologies AG, 81669 München (DE)
(72) Erfinder: AHLERS, Dirk, 80796 München (DE); WERNER, Wolfgang, 81545 München (DE)
(74) Vertreter: Kottmann, Heinz Dieter
(86) Internationale Anmeldenummer: PCT/DE2001/000908
(87) Internationale Veröffentlichungsnummer: WO 2001/069682

(56) Entgegenhaltungen:
- EP-A- 0 167 813
- EP-A- 0 822 600
- DE-C- 19 818 298
- US-A- 4 754 310
- US-A- 5 264 719

## Beschreibung

Die vorliegende Erfindung betrifft wie in Anspruch 1 formuliert ein Hochvolt-Halbleiterbauelement, mit einem Halbleitersubstrat eines ersten Leitungstyps, auf dem eine schwächer als das Halbleitersubstrat dotierte Halbleiterschicht eines zweiten, zum ersten Leitungstyp entgegengesetzten Leitungstyps als die Sperrspannung des Halbleiterbauelementes aufnehmende Driftstrecke vorgesehen ist, in der zueinander abwechselnd lateral ausgerichtete Halbleitergebiete des ersten und des zweiten Leitungstyps vorgesehen sind. Außerdem betrifft die vorliegende Erfindung ein Hochvoit-Halbleiterbauelement mit einem MOS-Feldeffekttransistor, der in.einem Halbleitersubstrat ausgebildet ist und eine mit seiner Drainelektrode verbundene Driftstrecke aufweist.

Bei einem aus US 4 754 310 bekannten Halbleiterbauelement sind in eine Oberfläche eines Halbleiterkörpers zwei Trenchelektroden im Abstand voneinander vorgesehen. Diese Trenchelektroden grenzen an Halbleiterbereiche unterschiedlichen Leitungstyps. Das heißt, eine erste Trenchelektrode.grenzt , an einen p-leitenden Bereich, während eine zweite Trenchelektrode in einem n-leitenden Bereich vorgesehen ist. Zwischen diesen beiden Bereichen unterschiedlichen Leitungstyps erstrecken sich lateral abwechselnd p- und n-leitende Gebiete, die elektrisch parallele Strompfade bilden, welche den Serienwiderstand im Bodybereich des Halbleiterbauelementes erheblich vermindern, ohne dessen Sperrfähigkeit zu beeinträchtigen.

Auch nach dem Kompensationsprinzip arbeitende Hochvolttransistoren haben sich lateral erstreckende und abwechselnd zueinander angeordnete n- und p-leitende Schichten, die bevorzugt durch Epitaxie hergestellt sind, wobei die Source- und Drainanschlüsse dieser Hochvolt-transistoren auf der gleichen Oberfläche eines Halbleiter-körpers vorgesehen sind.

Es gibt aber auch-Hochvolt-DMOS-Transistoren, die ebenfalls nach dem Kompensationsprinzip arbeiten und hierzu in der sogenannten Aufbautechnik realisiert sind, bei der vertikal verlaufende n- und p-leitende säulenförmige Gebiete in der die Sperrspannung aufnehmenden Driftstrecke vorgesehen sind. Diese Hochvolt-DMOS-Transistoren zeichnen sich durch eine erhebliche Verminderung des Einschaltwiderstandes, also durch einen enormen Ron-Gewinn aus. Die bei der Aufbautechnik verwendete Mehrfachepitaxie verursacht aber relativ hohe Kosten. Zur Vermeidung dieser Kosten wurde daher bereits daran gedacht, die säulenartigen Gebiete durch Trenchätzen und nachfolgende epitaktische Auffüllung herzustellen. Trotz umfangreicher Versuche hat sich bisher aber noch kein Weg gefunden, der eine Fertigung derartiger Hochvolt-DMOS-Transistoren in großem Umfang in befriedigender Weise erlaubt.

Im Einzelnen ist aus DE 198 18 298 C1 ein superniederohmiger vertikaler MOSFET bekannt, bei dem Source und Gate auf einer Oberfläche eines Halbleiterkörpers und Drain auf der zur einen Oberfläche gegenüberliegenden Oberfläche des Halbleiterkörpers vorgesehen sind und bei dem im Halbleiterkörper in einer Driftzone säulenartige, in der Richtung von der einen zur gegenüberliegenden Oberfläche verlaufende Zonen unterschiedlichen Leitungstyps angeordnet sind. Außerdem weist die Driftzone mehrere, sich senkrecht zu den säulenartigen Zonen erstreckende Bereiche abwechselnd entgegengesetzten Leitungstyps auf, die über die im gegenseitigen Abstand zueinander angeordneten säulenartigen Zonen kontaktiert sind. Dieser MOSFET wird durch Epitaxie- und Ionenimplantationsschritte hergestellt.

Es ist daher Aufgabe der vorliegenden Erfindung, ein Hochvolt-Halbleiterbauelement anzugeben, das nach dem Kompensätionsprinzip zu arbeiten vermag und relativ einfach herstellbar ist, so daß es sich durch niedrige Herstellungskosten auszeichnet.

Diese Aufgabe wird bei einem Hochvolt-Halbleiterbauelemennach Anspruch 1 erfindungsgemäß dadurch gelöst. Die Halbleitergebiete des ersten Leitungstyps sind durch eine durch die Halbleiterschicht geführte elektrisch leitende Verbindung mit dem Halbleitersubstrat verbunden, auf dem eine erste Elektrode angeordnet ist. Die Halbleitergebiete des zweiten Leitungstyps sind durch eine durch die Halbleitergebiete geführte weitere leitende Verbindung mit einer auf der Halbleiterschicht vorgesehenen zweiten Elektrode verbunden.

Das Hochvolt-Halbleiterbäuelement ist so an sich ein Vertikal-Bauelement, da die beiden Elektroden auf einander gegenüberliegenden Oberflächen des Halbleiterchips, vorgesehen sind. Es vereinigt aber in überraschend einfacher Weise die Vorteile von Lateralanordnungen und Vertikälaiiordnungen: Source- bzw. Drain-Anschluß eines sich vertikal erstreckenden Hochvolttransistors, der nach dem Kompensationsprinzip arbeitet, sind mit einer sich lateral äusdehnenden Driftstrecke versehen; dieser Source- bzw. Drain-Anschluß ist dabei so mit dem Halbleitersubstrat verbunden, daß eine Struktur mit gemeinsamer Source ("common source") oder mit gemeinsamer Drain ("common drain") entsteht.

Die Herstellungskosten, für das erfindungsgemäße Hochvolt-Halbleiterbauelement sind erheblich reduziert, da die Halbleitergebiete des ersten bzw. zweiten Leitungstyps bildende n- bzw. p-(oder p- und n-) leitende Schichten in einem Epitaxieschritt hergestellt werden können und die leitenden Verbindungen beispielsweise ohne weiteres aus mit n⁺- oder p⁺⁻dotiertem polykristallinem Silizium aufgefüllten Trenchgräben zu bilden sind. Selbstverständlich können auch anderegeeignete Materialien für diese leitenden Verbindungen gewählt werden. Dabei brauchen bezüglich der Form dieser Gräben und deren Oberflächenbeschaffenheit lediglich geringe Anforderungen erfüllt zu werden. Es muß nur sichergestellt werden, daß zwischen den Gräben und dem monokristallinen Halbleitermaterial, also vorzugsweise Silizium, ein pn-Übergang existiert, was durch Ausdiffusion erreicht werden kann.

Der Abstand zwischen den Halbleitergebieten des ersten und des zweiten Leitungstyps, also der Abstand zwischen n- und p-leitenden Schichten, läßt sich deutlich reduzieren, da dieser Abstand vollkommen unabhängig vom Raster der-das Hochvolt-Halbleiterbauelement bildenden Zellen ist. Typische Maße für diesen Abstand zwischen den Halbleitergebieten des ersten und des zweiten Leitungstyps liegen zwischen 1 und 5 µm. Die gesamte Dicke aller Halbleitergebiete des ersten und des zweiten Leitungstyps kann beispielsweise zwischen 5 und 30 µm liegen, wobei aber auch geringere oder höhere Werte möglich sind.

Durch eine Reduktion des Abstandes zwischen den Halbleitergebieten, also des Schichtabstandes zwischen den n- und p-leitenden Schichten kann die Dotierung der einzelnen Gebiete oder Schichten entsprechend erhöht werden.

Für einen Abstand von etwa 2 µm zwischen den Halbleitergebieten bzw. Schichten und einer gesamten Dicke der Driftstrecke von etwa 20 µm kann eine Reduzierung des Einschaltwiderstandes um einen Faktor von etwa 0,3 erwartet werden.

Von besonderem Vorteil ist es, daß bei dem erfindungsgemäßen Hochvolt-Halbleiterbauelement ein Randabschluß infolge des lateralen.Konzeptes der einander abwechselnden Halbleitergebiete unterschiedlichen Leitungstyps grundsätzlich nicht erforderlich ist, was bei kleinen Chipflächen eine erhebliche Flächeneinsparung bedeutet.

Eine vorteilhafte Weiterbildung der Erfindung besteht darin, daß zusätzlich Feldplatten an der Unterseite und/oder Oberseite der Driftstrecke angebracht werden. Unter der Oberseite der Driftstrecke ist dabei die Chipoberfläche zu verstehen. Durch diese Feldplatten wird die Verteilung des elektrischen Feldes in der Driftstrecke in günstiger Weise beeinflußt, da die Feldplatten dieselbe Wirkung wie eine variable "Säulendotierung" der eingangs erwähnten säulenartigen Gebiete erzielen, indem mit ihnen der für eine Avalanchefestigkeit notwendige dachförmige Feldverlauf in der Driftstrecke eingestellt werden kann. Zur Erreichung einer solchen hohen Avalanchefestigkeit ist auch eine höhere Dotierung in den Halbleitergebieten bzw. Schichten zweckmäßig, da eine dynamische Feldänderung im Durchbruchfall erst bei relativ hohen Strömen einsetzt.

Zur Lösung obiger Aufgabe ist bei einem Hochvolt-Halbleiterbauelement mit einem MOS-Feldeffekt'transistor, der in einem Halbleitersubstrat ausgebildet ist und eine mit seiner Drainelektrode verbundene Driftstrecke aufweist, vorgesehen, daß die Driftstrecke außerhalb des Source-Gate-Bereiches des MOS-Feldeffekttransistors gelegen und an diesem Bereich über ein Schaltelement angeschlossen ist. Das Schaltelement wird in bevorzugter Weise durch einen Junction-Feldeffekttransistor gebildet. Ist die Driftstrecke in der eingangs angegebenen Weise gestaltet, besteht der Junction-Feldeffekttransistor aus den Halbleitergebieten des ersten Leistungstyps und den durch diese unterbrochenen weiteren leitenden Verbindungen, wie dies weiter unten noch näher erläutert werden wird.

Bei diesem Hochvolt-Halbleiterbauelement ist die Pinch-off-Spannung (Ab,schaltspannung) des Junction-Feldeffekttransistors niedriger als die Durchbruchspannung zwischen den Halbleitergebieten des zweiten Leitungstyps und einer hochdotierten sourceseitigen "Säule" des ersten Leitungstyps, die im Source-Gate-Bereich bzw. Zellbereich die Halbleitergebiete.des ersten Leitungstyps miteinander verbindet. Das heißt, der Junction-Feldeffekttransistor schaltet ab, bevor ein Durchbruch im Source-Gate-Bereich bzw. Zellbereich des Halbleiterbauelements auftreten kann.

Bei beispielsweise einer Konfiguration mit gemeinsamer Drain ist somit die die n-leitenden Gebiete verbindende n⁺-leitende Säule aus zum Beispiel polykristallinem Silizium nicht zwischen den beiden elektrisch leitenden Verbindungen vorgesehen, d. h. die Driftstrecke ist von dem Zellbereich getrennt. Außerdem ist der durch die leitenden Verbindungen und die Halbleitergebiete des zu diesen leitenden Verbindungen entgegengesetzten Leitungstyps gebildete Junction-Feldeffekttransistor so dimensioniert, daß dessen Pinch-off-Spannung kleiner als die Durchbruchspannung für die p-leitenden Halbleitergebiete und die sourceseitige n⁺-leitende Säule ist.

Für eine Konfiguration mit gemeinsamer Source gelten bei entsprechender Änderung der Leitungstypen die gleichen Anforderungen.

Nachfolgend wird die Erfindung anhand der Zeichnungen näher erläutert. Es zeigen:
- Fig. 1: eine schematische Schnittdarstellung einer Konfiguration mit gemeinsamer Drain,
- Fig. 2: eine schematische Schnittdarstellung einer Konfiguration mit gemeinsamer Source,
- Fig. 3: eine schematische Schnittdarstellung eines konkreten Ausführungsbeispiels einer Source-Gate-Konfiguration für gemeinsame Drain und
- Fig. 4: einen Schnitt BB' durch das Ausführungsbeispiel von Fig. 3 und
- Fig. 5: ein schematisches Ersatzschaltbild für das Ausführungsbeispiel der Fig. 3 und 4.

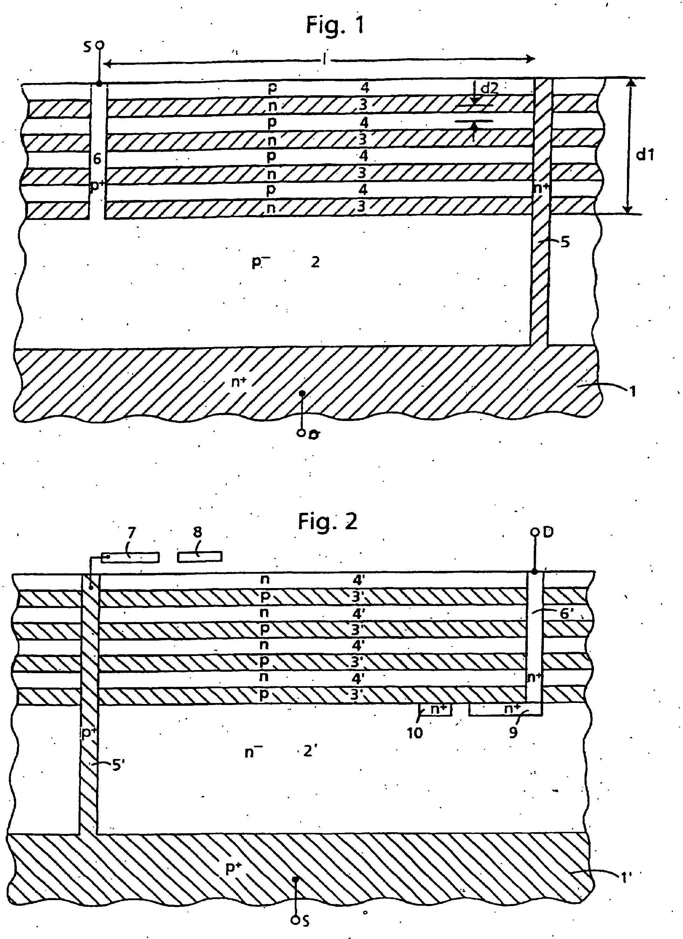

Fig. 1 zeigt eine Diodenstruktur einer Konfiguration mit gemeinsamer Drain aus einem n⁺-leitenden Siliziumsubstrat 1, auf dem eine p⁻-leitende Siliziumschicht 2 vorgesehen ist. In dieser p⁻-leitenden Siliziumschicht 2 befinden sich einander abwechselnd n- und p-leitende Gebiete oder Schichten 3, 4, die wie die Schicht 2 epitaktisch abgeschieden sein können. Die Schichten 3,-4 können eine Gesamtdicke d1 zwischen 5 und 30 µm haben, während der Abstand d2 zwischen den einzelnen Gebieten oder Schichten 3, 4 zwischen 1 und 5 µm liegen kann. Selbstverständlich sind hier auch von den obigen Bereichen abweichende Abmessungen möglich. Ebenso ist das Halbleitermaterial nicht auf Silizium beschränkt. Vielmehr können auch andere Halbleitermaterialien, wie beispielsweise SiC, A_{III}B_{V-}Halbleiter usw. zum Einsatz gelangen.

Wesentlich an der vorliegenden Erfindung ist nun, daß das n⁺⁻leitende Siliziumsubstrat 1, an dem ein Drainanschluß D angebracht ist, über eine leitende Verbindung 5 aus beispielsweise n⁺-leitendem polykristallinem Silizium mit den n-leitenden Gebieten oder Schichten 3 verbunden ist, und daß außerdem ein Sourceanschluß S über eine leitende säulenförmige Verbindung 6 aus beispielsweise p⁺-leitendem polykristallinem Silizium mit den p-leitenden Gebieten oder Schichten 4 verbunden ist. Anstelle von polykristallinem Silizium kann auch ein anderes geeignetes Leitermaterial verwendet werden, wie z. b. Metall.

Die leitenden Verbindungen 5, 6 können durch Trenchätzen, anschließendes Auffüllen dieser Trenche mit dem polykristaliinen Silizium und Ausdiffusion zur Verlagerung des pn-Übergangs in monokristallines Material in relativ einfacher Weise hergestellt werden, da die Anforderungen hinsichtlich der Form dieser Trenche und hinsichtlich der Oberflächenbeschaffenheit relativ gering sind: es ist lediglich erforderlich, daß die einzelnen Gebiete bzw. Schichten 3, 4 über die leitenden Verbindungen 5, 6 niederohmig mit den entsprechenden Anschlüssen D bzw. S verbunden sind. Anstelle von polykristallinem Silizium kann für die leitenden Verbindungen auch ein anderes Material, wie z. B. Metall oder insbesondere hochdotiertes Silizium verwendet werden. Der durch die Ausdiffusion gebildete pn-Übergang ist in Fig. 1 für die Verbindung 5 schematisch durch eine Strichlinie 14 dargestellt.

Fig. 2 zeigt eine schematische Darstellung der Source-Drain-. Anordnung einer Konfiguration mit gemeinsamer Source, wobei hier die mit den Bezugszeichen 1' bis 6' versehenen Teile gerade den zu den Teilen 1 bis 6 der Fig. 1 entgegengesetzten Leitungstyp haben. Das heißt, auf einem p⁺-leitende Siliziumsubstrat 1' befinden sich eine n⁻-leitende Siliziumschicht, auf welcher wiederum einander abwechselnd p-leitende Gebiete oder Schichten 3' oder n-leitende Gebiete oder Schichten 4' angeordnet sind, wobei das Siliziumsübstrat 1' über eine leitende Verbindung 5' aus p⁺-dotiertem polykristallinem Silizium mit den Gebieten oder Schichten 3' verbunden ist, während ein Drainanschluß D über eine n⁺⁻leitende Verbindung 6' aus polykristallinem Silizium an die n-leitenden Schichten 4' angeschlossen ist.

Zusätzlich zum Ausführungsbeispiel von Fig. 1 zeigt das Ausführungsbeispiel von Fig. 2 noch Feldplatten 7 bis 10, die, wie die Feldplatten 7 und 8 auf der Chipoberfläche in einer nicht gezeigten Isolierschicht vorgesehen sind oder sich, wie die Feldplatten 9 und 10, an der Unterseite der Gebiete 3' und 4' befinden. Die Feldplatten 7 und 8 können dabei beispielsweise aus Aluminium bestehen, während die Feldplatten 9 und 10 n⁺-leitende Zonen sind. Die Feldplatte 7 ist an die leitende Verbindung 5' angeschlossen, während die Feldplatte 8 floatend ist, und die Feldplatte 9 ist an die leitende Verbindung 6' angeschlossen, während die Feldplatte 10 floatend ist.

Durch diese Feldplatten kann die Verteilung des elektrischen Feldes in der Driftstrecke günstig beeinflußt werden, so daß die gleiche Wirkung wie mittels einer variablen Säulendotierung in Kompensationsbauelementen mit säulenartigen dotierten Gebieten erreicht wird.

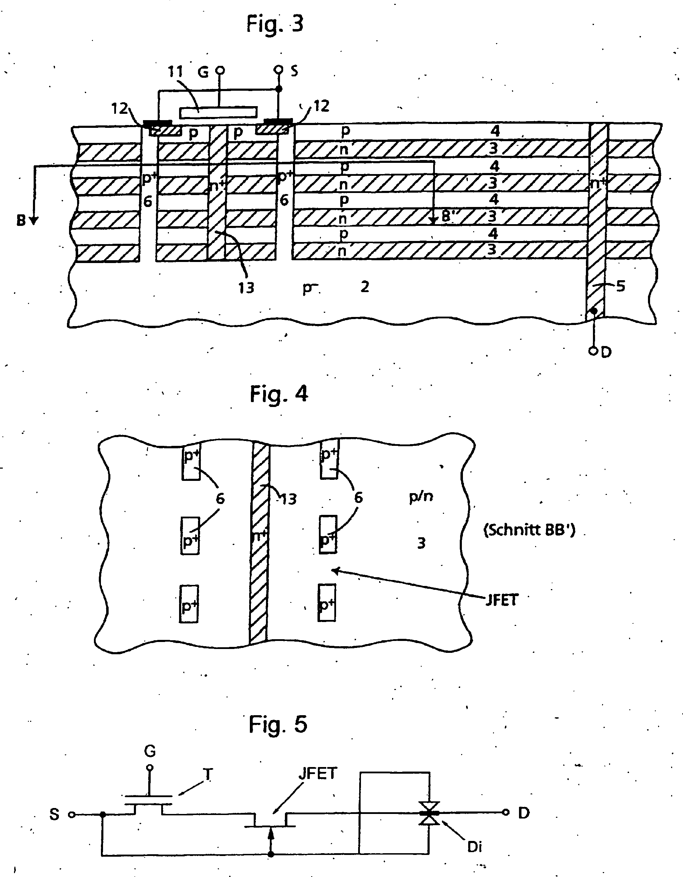

In Fig. 1 ist wie in Fig. 2 der Zellbereich mit insbesondere einer Sourcezone sowie einer Gateelektrode zur Vereinfachung der Darstellung nicht gezeigt. Dieser Zellbereich kann aber in der in Fig. 3, dargestellten Weise gestaltet sein, auf welche nachfolgend näher eingegangen wird. Fig. 1 und Fig. 2 zeigen also im wesentlichen die Driftstrecke mit einer Länge 1, die ungefähr 50 µm betragen kann. Diese Driftstrecke kann sich jeweils beidseitig an einen Zellbereich anschließen, wobei auch mehrere Zellbereiche, jeweils unterbrochen durch eine Driftstrecke, vorgesehen werden können.

Fig. 3 zeigt die Source-Gate-Anordnung für eine Konfiguration mit gemeinsamer Drain, also für das Ausführungsbeispiel der Fig. 1. Zusätzlich zu Fig. 1 ist hier noch ein Zellbereich aus einer Gateelektrode 11 für einen Gateanschluß G, einer Sourcezone 12 in dem obersten p-leitenden Gebiet 4 und einer n⁺-leitenden Verbindung 13, die in gleicher Weise wie die Verbindung 5 aufgebaut ist, gezeigt. Der Bereich zwischen den beiden n⁺-leitenden Verbindungen 5 und 13 in Fig. 3 bildet dabei eine Halbzelle. Die leitende Verbindung 5, die die einzelnen Gebiete oder Schichten 3 miteinander verbindet, muß dabei außerhalb des Bereiches zwischen der p⁺⁻leitenden Verbindung oder "Sourcesäule" 6 und der n⁺⁻leitenden Verbindung 13 liegen.

Ein durch die säulenförmigen Verbindungen 6 und die Schichten 3 gebildeter Junction-Feldeffekttransistor JFET (vgl. Fig. 4) sollte so dimensioniert sein, daß dessen Pinch-off-Spannung kleiner als die Durchbruchspannung zwischen den p-leitenden Gebieten 4 und der n⁺-leitenden Verbindung 13 ist. Dadurch schaltet der Junction-Feldeffekttransistor ab, bevor ein Durchbruch im Zellbereich oder in der Driftstrecke auftreten kann.

Fig. 5 zeigt noch ein Ersatzschaltbild des Hochvolt-Halbleiterbaulements von Fig. 3 und 4 mit einem MOS-Feldeffekttransistor aus dem Zellbereich, dem Junction-Feldeffekttransistor JFET, dessen Gate durch die Verbindungen 6 gebildet ist und dessen Kanal aus den n-leitenden Schichten 3 zwischen diesen Verbindungen 6 besteht, und Dioden Di aus den pn-Übergängen zwischen den Schichten 4 und der leitenden Verbindung 5.

## Patentansprüche

1. Hochvolt-Halbleiterbauelement mit einem Halbleitersubstrat (1, 1') eines ersten Leitungstyps, auf dem zueinander abwechselnd lateral ausgerichtete Halbleitergebiete (3, 4; 3', 4') des ersten und eines zweiten, zum ersten Leitungstyp entgegengesetzten Leitungstyps angeordnet sind, wobei die Halbleitergebiete (3, 3') des ersten Leitungstyps an das Halbleitersubstrat (1, 1') angeschlossen sind, auf dem eine erste Elektrode (D; S) angeordnet ist, und wobei die Halbleitergebiete (4, 4') des zweiten Leitungstyps an eine zweite Elektrode (S; D) angeschlossen sind, wobei
- zwischen dem Halbleitersubstrat (1, 1') und den Halbleitergebieten (3, 4; 3', 4') eine schwächer als das Halbleitersubstrat (1, 1') dotierte Halbleiterschicht (2, 2') eines zweiten, zum ersten Leitungstyp entgegengesetzten Leitungstyps als ein die Sperrspannung des Halbleiterbauelements aufnehmendes Gebiet vorgesehen ist, und wobei die Halbleiterschicht (2, 2') schwächer datiert ist als diejenigen Halbleitergebiete (4, 4'), die vom gleichen Leitungstyp wie die Halbleiterschicht (2, 2') sind,
- die Halbleitergebiete (3, 3') des ersten Leitungstyps durch eine durch die Halbleiterschicht (2, 2') geführte elektrisch leitende Verbindung (5, 5') mit dem Halbleitersubstrat (1, 1') verbunden sind, und
- die Halbleitergebiete (4, 4') des zweiten Leitungstyps durch eine durch die Halbleitergebiete (3, 4; 3', 4') geführte weitere leitende Verbindung (6, 6') mit der auf der Halbleiterschicht (2, 2') vorgesehenen zweiten Elektrode (S; D) verbunden sind.

2. Hochvolt-Halbleiterbauelement nach Anspruch 1,
**dadurch gekennzeichnet, daß**
die Halbleitergebiete (3, 3') des ersten Leitungstyps und die Halbleitergebiete (4, 4') des zweiten Leitungstyps schichtartig gestaltet sind.

3. Hochvolt-Halbleiterbauelement nach Anspruch 1 oder 2,
**dadurch gekennzeichnet, daß**
der Abstand zwischen den Halbleitergebieten (3, 3') des ersten Leitungstyps und den Halbleitergebieten (4, 4') des zweiten Leitungstyps etwa zwischen 1 und 5 µm beträgt.

4. Hochvolt-Halbleiterbauelement nach einem der Ansprüche 1 bis 3,
**dadurch gekennzeichnet, daß**
die Gesamtdicke der Halbleitergebiete (3, 4; 3', 4') des ersten und des zweiten Leitungstyps etwa zwischen 5 und 30 µm liegt.

5. Hochvolt-Halbleiterbauelement nach einem der Ansprüche 1 bis 4,
**dadurch gekennzeichnet, daß**
die leitende Verbindung (5, 5') und die weitere leitende Verbindung (6, 6') aus dotiertem polykristallinem Silizium oder hochdotiertem monokristallinem Silizium oder Metall bestehen, und daß bei Verwendung von polykristallinem Silizium ein dadurch gebildeter pn-Übergang (14) durch Ausdiffusion im monokristallinen Bereich verläuft.

6. Hochvolt-Halbleiterbauelement nach einem der Ansprüche 1 bis 5,
**gekennzeichnet durch**
Feldplatten (7 bis 9) auf der Oberseite und/oder Unterseite der Halbleitergebiete (3, 4; 3', 4').

7. Hochvolt-Halbleiterbauelement nach Anspruch 6,
**dadurch gekennzeichnet, daß**
die an der Unterseite der Halbleitergebiete (3, 4; 3', 4') gelegenen Feldplatten (9, 10) aus hochdotierten Bereichen des zweiten Leitungstyps bestehen.

8. Hochvolt-Halbleiterbauelement nach Anspruch 6 oder 7,
**dadurch gekennzeichnet, daß**
die Feldplatten (7, 9) mit der leitenden Verbindung (5, 5') und/oder der weiteren leitenden Verbindung (6, 6') verbunden sind.

9. Hochvolt-Halbleiterbauelement nach den Ansprüchen 1 bis 8, mit einem in dem Halbleitersubstrat ausgebildeten MOS-Feldeffekttransistor (T), dessen Source mit der zweiten Elektrode (S) verbunden ist und der eine mit der ersten Elektrode (D) verbundene Driftstrecke aufweist, wobei die Driftstrecke außerhalb des Source-Gate-Bereiches des MOS-Feldeffekttransistors (T) gelegen und an diesem Bereich über ein Schaltelement (JFET) angeschlossen ist.

10. Hochvolt-Halbleiterbauelement nach Anspruch 9,
**dadurch gekennzeichnet, daß**
das Schaltelement durch einen Junction-Feldeffekttransistor gebildet ist.

11. Hochvolt-Halbleiterbauelement nach Anspruch 9 oder 10,
**dadurch gekennzeichnet, daß**
die Driftstrecke nach einem der Patentansprüche 1 bis 8 gestaltet ist.

## Claims

1. High-voltage semiconductor component having a semiconductor substrate (1, 1') of a first conduction type on which laterally orientated semiconductor regions (3, 4; 3', 4') of the first conduction type and of a second conduction type which is opposed to the first conduction type are alternately arranged, the semiconductor regions (3, 3') of the first conduction type being connected to the semiconductor substrate (1, 1') on which a first electrode (D; S) is arranged, and the semiconductor regions (4, 4') of the second conduction type being connected to a second electrode (S; D),
- between the semiconductor substrate (1,1') and the semiconductor regions (3, 4; 3', 4'), a semiconductor layer (2, 2') - which is more weakly doped than the semiconductor substrate (1, 1') - of a second conduction type - which is opposed to the first conduction type - being provided as a region which takes up the reverse voltage of the semiconductor component, and the semiconductor layer (2 ; 2') being more weakly doped than those semiconductor regions (4, 4') which are of the same conduction type as the semiconductor layer (2 ; 2'),
- the semiconductor regions (3, 3') of the first conduction type being connected to the semiconductor substrate (1, 1') by means of an electrically conductive connection (5, 5') routed through the semiconductor layer (2, 2'), and
- the semiconductor regions (4, 4') of the second conduction type being connected, by means of a further conductive connection (6, 6') routed through the semiconductor regions (3, 4; 3', 4'), to the second electrode (S; D) which is provided on the semiconductor layer (2, 2').

2. High-voltage semiconductor component according to Claim 1, **characterized in that** the semiconductor regions (3, 3') of the first conduction type and the semiconductor regions (4, 4') of the second conduction type are formed in the manner of layers.

3. High-voltage semiconductor component according to Claim 1 or 2, **characterized in that** the distance between the semiconductor regions (3, 3') of the first conduction type and the semiconductor regions (4, 4') of the second conduction type is approximately between 1 and 5 µm.

4. High-voltage semiconductor component according to one of Claims 1 to 3, **characterized in that** the overall thickness of the semiconductor regions (3, 4; 3', 4') of the first and second conduction types is approximately between 5 and 30 µm.

5. High-voltage semiconductor component according to one of Claims 1 to 4, **characterized in that** the conductive connection (5, 5') and the further conductive connection (6, 6') are composed of doped polycrystalline silicon or highly doped monocrystalline silicon or metal, and **in that**, when polycrystalline silicon is used, a pn-type junction (14) which is formed as a result by means of outdiffusion extends in the monocrystalline region.

6. High-voltage semiconductor component according to one of Claims 1 to 5, **characterized by** field plates (7 to 9) on the upper side and/or underside of the semiconductor regions (3, 4; 3', 4').

7. High-voltage semiconductor component according to Claim 6, **characterized in that** the field plates (9, 10) which are positioned on the underside of the semiconductor regions (3, 4; 3', 4') are composed of highly doped areas of the second conduction type.

8. High-voltage semiconductor component according to Claim 6 or 7, **characterized in that** the field plates (7, 9) are connected to the conductive connection (5, 5') and/or to the further conductive connection (6, 6').

9. High-voltage semiconductor component according to Claims 1 to 8 having a MOS field-effect transistor (T) formed in the semiconductor substrate whose source is connected to the second electrode (S) and which has a drift path connected to the first electrode (D), the drift path being located outside the source-gate region of the MOS field-effect transistor (T) and is connected to this area by means of a switching element (JFET).

10. High-voltage semiconductor component according to Claim 9, **characterized in that** the switching element is formed by a junction field-effect transistor.

11. High-voltage semiconductor component according to Claim 9 or 10, **characterized in that** the drift path is formed according to one of Patent Claims 1 to 8.

## Revendications

1. Composant à semi-conducteur à haute tension comprenant un substrat (1, 1') semi-conducteur d'un premier type de conductivité, sur lequel sont disposées des zones (3, 4 ; 3', 4') semi-conductrices dirigées latéralement en alternance les unes par rapport aux autres du premier type de conductivité et d'un deuxième type de conductivité opposé au premier type de conductivité, les zones (3, 3') semi-conductrices du premier type de conductivité étant raccordées au substrat (1, 1') semi-conducteur sur lequel est disposée une première électrode (D ; S), et les zones (4, 4') semi-conductrices du deuxième type de conductivité étant raccordées à une deuxième électrode (S ; D),
- il est prévu entre le substrat (1, 1') semi-conducteur et les zones (3, 4 ; 3', 4') semi-conductrices une couche (2, 2') semi-conductrice, dopée plus faiblement que le substrat (1, 1') semi-conducteur, d'un deuxième type de conductivité opposé au premier type de conductivité, en tant que zone absorbant la tension de blocage du composant à semi-conducteur, et dans lequel la couche (2, 2') semi-conductrice est dopée plus faiblement que les zones (4, 4') semi-conductrices qui sont du même type de conductivité que la couche (2, 2') semi-conductrice,
- les zones (3, 3') semi-conductrices du premier type de conductivité sont reliées au substrat (1, 1') semi-conducteur par une liaison (5, 5') conductrice de l'électricité passant à travers la couche (2, 2') semi-conductrice, et
- les zones (4, 4') semi-conductrices du deuxième type de conductivité sont reliées à la deuxième électrode (S ; D) prévue sur la couche (2, 2') semi-conductrice par une autre liaison (6, 6') conductrice passant à travers les zones (3, 4; 3', 4') semi-conductrices.

2. Composant à semi-conducteur à haute tension suivant la revendication 1,
**caractérisé en ce que** les zones (3, 3') semi-conductrices du premier type de conductivité et les zones (4, 4') semi-conductrices du deuxième type de conductivité sont conformées en couches.

3. Composant à semi-conducteur à haute tension suivant la revendication 1 ou 2,
**caractérisé en ce que** la distance entre les zones (3, 3') semi-conductrices du premier type de conductivité et les zones (4, 4') semi-conductrices du deuxième type de conductivité est comprise entre environ 1 à 5 µm.

4. Composant à semi-conducteur à haute tension suivant l'une des revendications 1 à 3,
**caractérisé en ce que** l'épaisseur totale des zones (3, 4 ; 3', 4') semi-conductrices du premier et du deuxième type de conductivité est comprise entre environ 5 et 30 µm.

5. Composant à semi-conducteur à haute tension suivant l'une des revendications 1 à 4,
**caractérisé en ce que** la liaison (5, 5') conductrice et l'autre liaison (6, 6') conductrice est en silicium polycristallin dopé ou en silicium monocristallin très dopé ou en métal, et **en ce que**, lorsque l'on utilise du silicium polycristallin, une jonction (14) pn ainsi formée s'étend par diffusion dans la zone monocristalline.

6. Composant à semi-conducteur à haute tension suivant l'une des revendications 1 à 5,
**caractérisé par** des plaques (7 à 9) de champ du côté supérieur et/ou du côté inférieur des zones (3, 4 ; 3', 4') semi-conductrices.

7. Composant à semi-conducteur à haute tension suivant la revendication 6,
**caractérisé en ce que** les plaques (9, 10) de champ sur le côté inférieur des zones (3, 4 ; 3', 4') semi-conductrices sont constituées de parties très dopées du deuxième type de conductivité.

8. Composant à semi-conducteur à haute tension suivant la revendication 6 ou 7,
**caractérisé en ce que** les plaques (7, 9) de champ sont reliées à la liaison (5, 5') conductrice et/ou à l'autre liaison (6, 6') conductrice.

9. Composant à semi-conducteur à haute tension suivant l'une des revendications 1 à 8, ayant un transistor (T) à effet de champ MOS qui est constitué dans le substrat semi-conducteur dont la source est reliée à la deuxième électrode (5) et qui a une section de Drift reliée à la première électrode (D) de drain, la section de Drift étant à l'extérieur de la partie de source-grille du transistor (T) à effet de champ MOS et étant raccordée à cette région par un élément (JFET) de commutation.

10. Composant à semi-conducteur à haute tension suivant la revendication 9,
**caractérisé en ce que** l'élément de commutation est formé par un transistor à effet de champ à jonction.

11. Composant à semi-conducteur à haute tension suivant la revendication 9 ou 10,
**caractérisé en ce que** la section de Drift est conformée suivant l'une des revendications 1 à 8.
